Europäisches Patentamt

European Patent Office

Office européen des brevets

(19)

(11) Publication number: **0 159 663**
A2

(12) **EUROPEAN PATENT APPLICATION**

(21) Application number: 85104645.8

(22) Date of filing: 17.04.85

(51) Int. Cl.⁴: **H 01 L 29/78,** H 01 L 29/74, H 01 L 21/28

(30) Priority: 26.04.84 US 604333

(43) Date of publication of application: 30.10.85 Bulletin 85/44

(84) Designated Contracting States: DE FR GB NL

(71) Applicant: GENERAL ELECTRIC COMPANY, 1 River Road, Schenectady New York 12305 (US)

(72) Inventor: Temple, Victor Albert Keith, Main Street, Clifton Park New York (US)

(74) Representative: Schüler, Horst, Dr. European Patent Attorney et al, Kaiserstrasse 41, D-6000 Frankfurt/Main 1 (DE)

(54) High-density V-groove MOS-controlled thyristors, insulated-gate transistors, and MOSFETs, and methods for fabrication.

(57) Various vertical-channel MOS-gated power semiconductor devices attain a high current capacity through minimization of various lateral distances within the devices and also attain essentially minimum cell size. Processes for fabricating these devices employ a first mask to define both the location of a channel-terminating upper electrode region and the location of a V-groove, thereby avoiding any mask alignment at this point in the process. In one embodiment, the first mask comprises silicon nitride, and is eventually removed. In another embodiment, the first mask comprises molybdenum silicide, and remains in the device structure to ultimately serve as the upper main electrode. Two different techniques are employed for opening contact windows through the polysilicon gate electrode material, and different structures result. In one of these, a plurality of short windows are provided generally at right angles to the V-grooves.

ACTORUM AG

# HIGH-DENSITY V-GROOVE MOS-CONTROLLED THYRISTORS, INSULATED-GATE TRANSISTORS, AND MOSFETs, AND METHODS FOR FABRICATION

## Cross-Reference to Related Applications

The present application is related to commonly-assigned, copending European applications 83103501.9 and 83103196.8.

## BACKGROUND OF THE INVENTION

The present invention relates to insulated-gate semiconductor devices employing "V"-shaped grooves and having various improved characteristics, and methods for their manufacture. The invention more particularly relates to such structures and fabrication methods which result in high cell density and minimal lateral distances in the individual device cells, resulting in improved device performance. In addition, threshold voltage and sheet resistance can both be adjusted in a manner such that both can be suitably low.

The structures and methods of the present invention are applicable to a number of specific semiconductor devices, all of which may be categorized as metal-oxide-semiconductor-, or MOS-, gated vertical-channel power switching semiconductor devices. While the various specific devices differ markedly in the number of active device layers and in their manner of operation, the devices all employ a similar upper structure for which similar fabrication techniques may be used. Three such devices are a MOS-controlled thyristor, an insulated-gate transistor, and an insulated-gate field-effect transistor. The first two of these are summarized in some detail below.

One particularly important device, to which the structures and methods of the present invention are applicable, is termed, generically, an MOS-controlled thyristor (MCT), a specific form of which may conveniently be referred to as a metal-oxide-semiconductor turn-off thyristor (MOSTOT). Various specific MOSTOT embodiments generally employing diffused region MOS (DMOS) fabrication techniques are disclosed in the European application 82109164.2, which is hereby expressly incorporated by reference.

Briefly, a MOSTOT is a four-layer thyristor device which additionally includes a fifth device region and an MOS-gated channel region defining a "bypass", enhancement-mode MOS field-effect transistor (MOSFET) which, when gated into conduction, bypasses charge carriers from an intermediate base region, for example the P base region, to one of the device main terminal electrodes, for example the cathode electrode, to turn the thryistor device off. As is well known, a thyristor has a latching characteristic such that, once gated into conduction, it remains conducting until current through the device decreases below a predetermined holding current level. This latching characteristic is a disadvantage in many specific circuit applications, and turn-off capability is accordingly a desirable feature. In general, the lower the resistance of the bypass carrier current carrier path, the greater the amount of device current that can be turned off.

Another specific type of three-terminal power switching semiconductor device is known as an insulated-gate transistor (IGT), various forms of which are disclosed in commonly-assigned German patent application P 31 47 075.0, relating to a ————————— ——————————————————————— GATE ENHANCED RECTIFIER. (It may be noted that a "gate enhanced rectifier", or "GERECT", is referred to herein as an insulated-gate transistor, or "IGT". It may further be noted that this same device has also been referred to as an "Insulated Gate-Rectifier", or "IGR". All three of these terms, "GERECT", "IGR", and "IGT" are intended to mean the same device, which is hereinafter referred to as an IGT.)

Briefly, an IGT is a normally non-latching four-layer semiconductor device having an insulated gate for controlling current flow between its main electrodes, i.e., between its anode and cathode terminals. An IGT differs from a four-layer PNPN thyristor, even though some forms of IGT are superficially somewhat similar structurally to typical MOS-gated silicon-controlled rectifier (SCR) or thyristor structures, and even though an IGT may be considered as including a parasitic thyristor. Significantly, in the normal operation of an IGT, the gate electrode maintains both turn-on and turn-off control of current flow through the device, and the parasitic thyristor is not permitted to latch into a conducting state.

Accordingly, in an IGT, it is essential that one or more techniques be employed to inhibit the parasitic thyristor inherent in the structure from operating, which would undesirably latch the IGT into a conducting state with consequent loss of gate control. A primary approach is to employ in the IGT cathode-to base shorts (hereinafter "shorts") with a high density relative to the density of shorts employed in a thyristor structure. However, no matter what technique for avoiding parasitic operation is employed, the factors leading to turn-on of the parasitic thyristor become more predominant as current flow through the device increases. As a result, an IGT has a maximum current rating which must not be exceeded if latch-on of the device is to be avoided. Similarly, it will be appreciated that any additional measures which may be provided to inhibit the parasitic thyristor action in an IGT are advantageous. It may be noted that the tendency for the parasitic thyristor in an IGT to latch on is analyzed in detail in the above cross-referenced European applications 83103501.9 and 83103196.8. Various structures directed to these ends are disclosed in these applications 83103501.9 and 83103196.8.

In the context of the V-groove aspect of the subject structures, it may be noted that MOSFETs have previously been disclosed in the prior art as both diffused region-MOS (DMOS) and V-groove-MOS (VMOS) devices. However, it is believed that MCTs of V-groove configuration have not heretofore been previously disclosed.

It will be appreciated that the term MOS or MOS-gated is employed herein in a generic sense for convenience. In particular, the term "metal" in "metal-oxide-semiconductor" connotes, as is known in the art, metal or other highly-conductive material, such as highly-doped polysilicon. Similarly, the term "oxide" connotes an oxide of semiconductor material, or another insulating layer.

## SUMMARY OF THE INVENTION

Accordingly, it is an object of the invention to provide structures and techniques for improving the performance of MCTs and IGTs by reducing certain lateral distances within the devices.

It is a more particular object of the invention to provide MCTs with improved turn-off characteristics by reducing the longest distance that carriers must travel to reach a short when the bypass MOSFET is gated into conduction.

It is another, more particular object of the invention to provide improved IGTs by reducing the lateral voltage drop in the device base region which tends to forward-bias the source/base PN junction into conduction, thereby increasing the maximum operating current of the IGT before the IGT latches on and gate control is lost.

It is another object of the invention to provide methods for fabricating minimum cell size devices which avoid critical mask alignment steps in the photolithographic masking process.

It is yet another object of the invention to provide vertical-channel MOSFET structures, with reduced cell size and reduced lateral distances.

Briefly, and in accordance with one overall concept of the invention, a manufacturing process is provided which advantageously employs a first mask to define both the location of a channel-terminating upper electrode region and the location of a V-groove, thereby entirely avoiding any mask alignment requirement whatsoever, let alone a critical mask alignment at this particular point in the process. Moreover, this same mask is employed in part for a third purpose, that of defining the locations of upper main electrode contacts.

In one embodiment, this first mask comprises silicon nitride which serves, successively, as a diffusion mask, a non-isotropic etchant mask, and a selective oxidation mask. This silicon nitride mask is ultimately removed to expose silicon on the upper principal surface of the device immediately prior to upper electrode metallization.

In another embodiment, this first mask comprises a refractory metal silicide, such as molybdenum silicide, which remains in the device structure and ultimately serves as the upper main electrode. The ultimate device structure formed by this process, rather than including elongated gate electrode runs, as is usual in most MOS-gated device structures, has elongated upper main electrode runs. Molybdenum silicide has the characteristic that the surface thereof can be oxidized to form an isolation insulation layer, permitting the entire upper portion of the device to be covered with gate electrode metallization.

In the embodiments employing a silicon nitride mask, the gate electrode preferably comprises highly-doped, and thus highly-conductive, polysilicon. The upper main termal metallization contacts the device upper regions through contact windows opened in the polysilicon gate electrode layer employing a second mask.

In accordance with the invention, two different techniques for opening contact windows through the polysilicon gate electrode material are provided. Both of these techniques employ a second mask. In one technique, the upper main electrode contact windows are parallel to and substantially co-extensive with the V-grooves. Thus, polysilicon gate electrode material remains essentially only within the V-grooves, and upper main electrode metallization contacts the remaining upper principal surface area of the device. In the preferred embodiments, this technique requires that the second mask be aligned with respect to the first mask with a micron alignment tolerance.

In the other technique, the upper main contact windows are at generally right angles to the V-grooves. A plurality of short windows are employed, but the windows are at least long enough to span a pair of channel-terminating upper electrode regions. This particular form sacrifices some gate width, but eliminates all critical alignment steps for the MCT or IGT.

As particularly directed to a process for manufacturing an improved insulated-semiconductor device of V-groove configuration, such as a MOSTOT, an IGT, or a MOSFET, a semiconductor wafer is provided having a principal surface and including at least first, second and third successive contiguous layers. The first layer is of one conductivity type and extends to the principal surface and includes at least first, second and third successive contiguous layers. The first layer is of one conductivity type and extends to the principal surface, and the second layer is of opposite conductivity type. The third layer is of the one conductivity type. For an MCT or an IGT, a fourth layer is provided, of the same conductivity type as the second layer.

A layer of material capable of serving as a first mask is formed on the principal surface. At least one elongated opening is next formed in the first mask layer to define the ultimate location of a V-groove.

The first mask layer is first used as a diffusion mask. Impurities are introduced into the first semiconductor layer, through the openings in the first mask. These impurities, which also may be termed dopant, are selected to form at the principal surface a channel-terminating electrode region of the opposite conductivity type. The impurities are at least laterally diffused part way under the mask layer to define the channel-terminating electrode region, while leaving a portion of the first layer extending to the principal surface.

The first mask layer is next employed as an etch resist mask to form, below the mask opening, a V-groove extending from the principal surface through the first semiconductor layer, and part way into the second layer. As is known in the art, the bottoms of the V-grooves may be flat so as to define what are sometimes termed U-grooves, and the term V-groove is employed herein in a generic sense to include these and related groove structures.

Next, a gate insulating layer is formed on the sides of the V-groove and a gate electrode is formed on the gate insulating layer.

A final step in the overall fabrication of the process is that of providing an upper main electrode in electrical contact with the channel-terminating upper electrode region and with the extending portion of the first semiconductor layer.

In addition to the processes of the invention as summarized above, various novel device structures result from these processes.

One of these novel device structures is a MOSTOT of V-groove configuration. The V-groove MOSTOT comprises a semiconductor body having first and second opposed principal surfaces and including first, second, third and fourth successive layers of alternate conductivity type. The first and third layers are of one conductivity type, for example, of N conductivity type, and the second and fourth layers are of opposite conductivity type, in this example, P conductivity type.

The first layer is adjacent the first (upper) principal surface and includes two portions of differing doping concentration. One of these portions has a relatively higher doping concentration and is immediately adjacent the first principal surface. For example, this one portion comprises an $N^+$ emitter. The other of the portions has a relatively lower doping concentration and is separated from the first principal

RD-15,248

0159663

surface by the $N^+$ emitter. In an MCT, this first layer portion may be termed an N emitter.

The device structure additionally includes a V-groove extending from the first principal surface through the first layer (N emitter) into the second layer (P base) such that at least the N emitter intersects a side of the V-groove along a lower portion of the V-groove.

A channel-terminating upper electrode region of the opposite conductivity type, in this example a $P^+$ MOSFET terminal region, is formed within the first layer immediately adjacent an upper portion of the V-groove and intersects both the first principal surface and the V-groove upper portion. The channel-terminating upper electrode region (P+ MOSFET terminal region) and the second layer (P base) together define the length of the channel region therebetween and within the N emitter portion.

A first main terminal electrode is provided in electrical contact, at the first principal surface, with the $N^+$ emitter and the $P^+$ MOSFET terminal region. A second main terminal electrode is provided in electrical contact, at the second principal surface, with the fourth layer, the MOSTOT $P^+$ emitter. Finally, an insulated gate electrode overlies the channel region and is configured such that an inversion channel electrically connecting the $P^+$ MOSFET terminal region and the P base region is induced in the channel region upon application to the gate electrode of a bias voltage having predetermined polarity and magnitude, for example, a negative gate voltage.

Other novel device structures provided in accordance with the invention include structures wherein the upper main contact windows defined by the second mask layer through the polysilicon gate electrode are at generally right angles to the V-grooves, as well as the structures which include molybdenum silicide upper main terminal electrodes extending to remote upper main terminal contact regions.

As a result of the methods and structures of the present invention, FET channel density is high. In other words, there are relatively large numbers of channels per unit of chip area. This is advantageous in all device structures. The use of a single mask to serve multiple masking functions significantly results in all necessary device regions being provided in a relatively small unit cell area. This is particularly significant in the case of a MOSTOT, where each unit cell must include an $N^+$ emitter, a $P^+$ MOSFET terminal region, an N emitter, a P base, a channel region, a gate electrode, and an upper main terminal electrode. Each of these regions is essential to the overall device and, in the absence of the present invention, would be larger in size. Employing the fabrication techniques of the invention, the structures can be fabricated with a 5-micron linewidth and a 2-micron alignment tolerance, as these terms are employed in the art.

In addition, the invention advantageously reduces certain parasitic effects in MCTs and IGTs. While these parasitic effects are different in detail in MCTs and IGTs, they are both related to lateral distance which, as is stated above, is minimized by the subject invention.

11

## BRIEF DESCRIPTION OF THE DRAWINGS

While the novel features of the invention are set forth with particularity in the appended claims, the invention, both as to organization and content, will be better understood and appreciated from the following detailed description taken in conjunction with the drawings, in which:

FIG. 1 is a schematic, cross-sectional view of a portion of one form of IGT in accordance with the invention;

FIG. 2A - 2E depict several process steps of a method for fabricating the device of FIG. 1;

FIG. 3A depicts a further process step, subsequent to the step of FIG. 2E for fabricating the device of FIG. 1;

FIG. 3B depicts a gross misalignment of the gates of the FIG. 3A device, which misalignment, however, is not fatal to the device;

FIG. 3C depicts a technique, requiring an extra mask, for ensuring contact by an upper electrode (not shown) to the MOSFET terminal regions of the MCT or IGT, which technique remedies the gate misalignment shown in FIG. 3B.

FIGS. 4A and 4B depict process steps which are an alternative to the process step of FIG. 3A, and which more specifically depict steps for opening main electrode contact windows at generally right angles to the V-grooves;

FIG. 5 is a schematic cross-sectional view of an IGT employing molybdenum silicide upper main electrodes;

FIGS. 6A - 6D depict steps in a process for fabricating the FIG. 5 device;

FIG. 7 is a schematic cross-sectional view of a portion of a MOSTOT in accordance with the invention, comparable in regard to fabrication procedure to the IGT of FIG. 1;

FIG. 8 is a schematic cross-sectional view of a portion of a MOSTOT which may be fabricated employing a process similar to the fabrication process used to make the FIG. 5 IGT.

## DETAILED DESCRIPTION

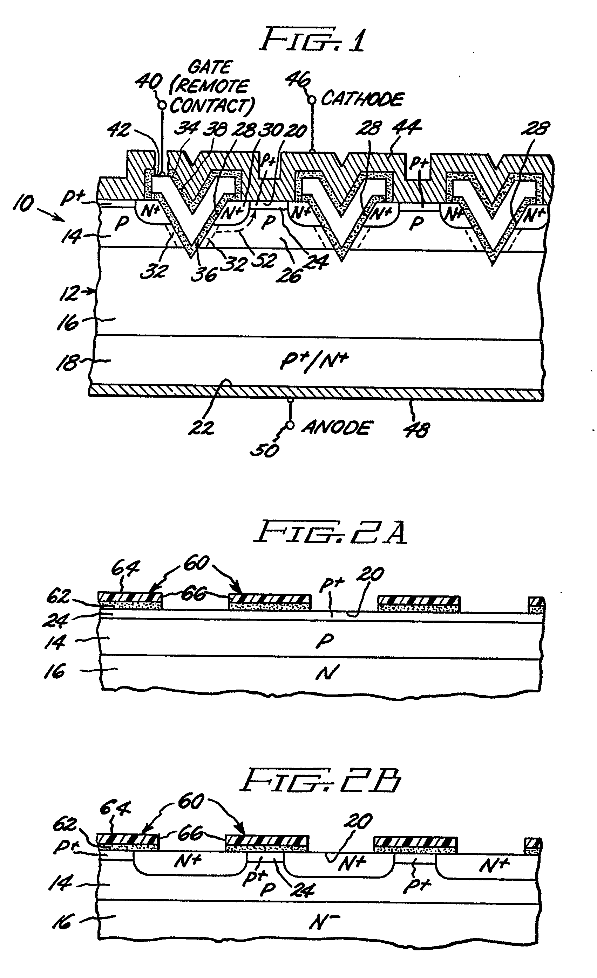

Referring first to FIG. 1, depicted is a schematic cross-sectional view of the active portion of a V-groove IGT, generally designated 10, fabricated in accordance with the process of the present invention. The IGT 10 comprises a semiconductor body 12, such as silicon, including first, second and third successive layers 14, 16 and 18, respectively, extending between first and and second opposed principal surfaces 20 and 22, respectively, of the body 12.  The first and third layers 14 and 18 are of one conductivity type, in this example of P conductivity type, and the second layer 16 is of N conductivity type.  More particularly, the first layer 14 comprises an IGT P base region, the second layer 16 comprises an IGT $N^-$ base region, and the third layer 18 comprises an IGT $P^+$ anode region.

In FIG. 1, it may be noted that the $P^+$ anode region may alternatively be an $N^+$ terminal region.  In this alternative case, the overall device comprises an N-channel power MOSFET wherein the $N^+$ layer 18 is termed the drain region, and the $N^-$ layer 16 is termed the $N^-$ drift region.

The first layer 14 in turn includes two portions 24 and 26 of differing doping concentration. The portion 24 has the higher doping concentration, is accordingly designated as a P$^+$ region, and is immediately adjacent the first principal surface 20. The other portion 26 has a relatively lower doping concentration and is separated from the first principal surface 20 by the portion 24.

In accordance with VMOS fabrication techniques, V-grooves 28 extend from the first principal surface 20 through the P-base layer 14 partly into the N$^-$ base layer 16 such that at least the other portion 26 of the P base layer 14 abuts the sides of the V-grooves 28 along lower portions of the V-grooves.

A channel-terminating upper electrode region 30 of the opposite conductivity type is formed within the first layer 14 immediately adjacent an upper portion of the V-groove 28 and abuts both the first principal surface 20 and the V-groove upper portion. In the case of an IGT, region 30 is an N$^+$ cathode region 30. The N$^+$ cathode region 30 and the N$^-$ base layer 16 together define the length of a channel region 32, which channel region 32 extends therebetween within the P-base region 14.

An insulated gate electrode 34 of highly-doped polysilicon, for example, overlies the channel region 32 and is configured such that an inversion channel electrically connecting the N$^+$ cathode region 30 and the N$^-$ base 16 is induced in the channel region 32 upon application of a suitable bias voltage to the polysilicon gate electrode 34. The polysilicon gate electrode 34 is insulated from the channel region 32 by gate insulating oxide 36, such as silicon dioxide, and is encased on its upper portions by isolation insulation 38, also preferably comprising silicon dioxide. A device gate terminal 40 is electrically connected to the polysilicon gate electrode 34 via a remote gate contact, represented at 42.

It will be appreciated that the polysilicon gate electrodes of the various unit cells are, in accordance with conventional practice, connected together in a comb-like arrangement and all are connected to the device gate terminal 40 at a location away from the active, or current-carrying region, of the device.

To complete the FIG. 1 device structure, a first main terminal electrode, i.e. a cathode electrode 44, is in electrical contact at the first principal surface 20 with the P base layer 14 and with the $N^+$ cathode region 30. Thus, the P base layer 14 is shorted to the cathode metal 44. The cathode metallization 44 is more particularly connected to the $P^+$ extending portion 24 which, as will be appreciated, accordingly aids in achieving a relatively lower resistance shorting contact between the cathode metallization 44 and the P base region 14 than would be the case if the portion 24 were doped merely to a reference concentration. At the same time, this particular structure facilitates ease of inversion of the channel region 32 since the channel region 32 is included in the P base portion 26 of relatively lower impurity concentration. The metallization 44 is connected to a device cathode terminal 46.

Finally, device anode metallization 48 is provided in electrical contact at the second principal surface 22 with the $P^+$ anode region 18, and is connected to a device anode terminal 50.

In the general operation of the FIG. 1 IGT device 10, the device supports forward conduction when a positive voltage is applied to the gate electrode 34 to induce, through inversion, an N type conduction channel in the channel region 32 between the $N^+$ cathode region 30 and the $N^-$ base region 16. Electrons from the cathode region 30 are conducted via the induced conduction channel 32 into the $N^-$ base region 16. At the same time, holes are injected from the $P^+$ anode region 18 into the $N^-$ base region 16. Current flow through the IGT 10 occurs due to the recombination of these electrons and holes in the $N^-$ base region 16. To turn off the device 10, positive gate voltage is removed from the gate electrode 34, and the conduction channel 32 is no longer induced. At this point, the IGT device no longer sustains conduction.

As summarized above, a parasitic thyristor is inherently present in the IGT, comprised of $N^+$ regions 30, P region 14, $N^-$ region 16 and $P^+$ region 18. Various factors leading to the eventual undesirable latching-on of the parasitic thyristor become more pronounced as current flow through the device increases. It is desirable to minimize as many of these factors as possible.

One of these adverse factors is voltage drop within the P base region 14 since a parasitic hole current flows generally along the path represented by arrow 52. This path 52 defines for the most part a lateral distance, since the $N^+$ source regions 30 are fabricated to be very shallow. Hole current flow in path 52, accordingly, may be characterized as resulting in a lateral voltage drop. In brief summary, hole current flowing along the representative path 52 tends to forward bias the PN junction between the P base 14 and the $N^+$ cathode 30. If allowed to increase above a threshold level, this forward bias results in undesirable latch-on of the parasitic thyristor. This tendency is discussed in greater detail in the above-cross-referenced applications 83103501.9 and 83103196.8.

The present invention minimizes this particular parasitic effect by minimizing the lateral length of the current path 52. In addition, the $P^+$ extending portion 24 of the P base region 14 aids in providing a low-resistance ohmic contact to the P base region 14, to further minimize this parasitic effect.

In an exemplary structure, the length of the channel 32 (i.e., a length roughly equal to the thickness of the P base layer below the $N^+$ cathode 30) is about 1.5 microns. Cell repeat distance is about 15 microns, and the maximum distance along the path 52 to the short is about 2.5 microns. The channel layer 26 has a doping concentration of about $10^{17}/cm^3$. This results in a sheet resistance of about 550 ohms per square, and a maximum lateral drop at 1000 Amps/cm² of about 100 millivolts. Latching current density is about 10,000 Amps/cm², based on a 40% hole current fraction and a 0.5 volt lateral latching voltage threshold. The structure has about 13 meters/cm² of channel width.

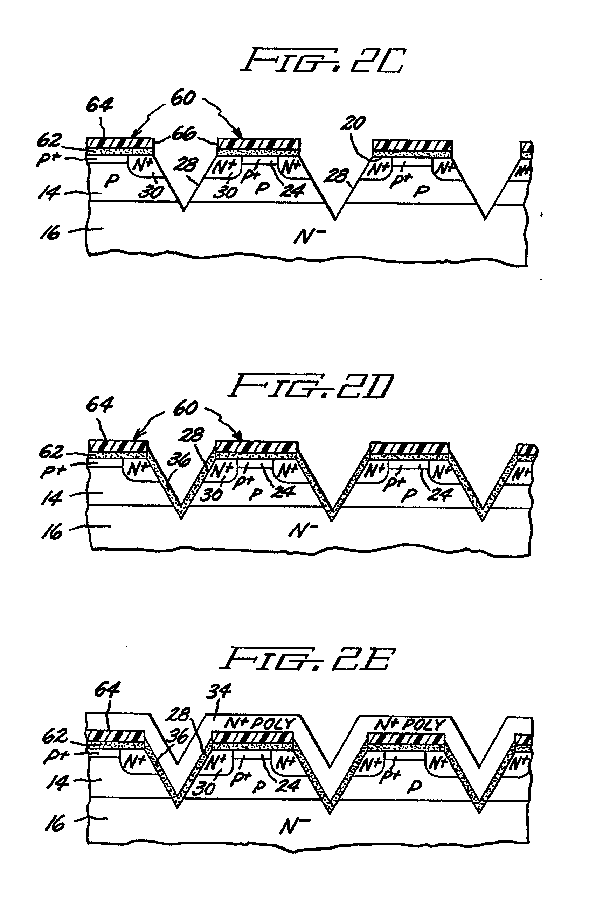

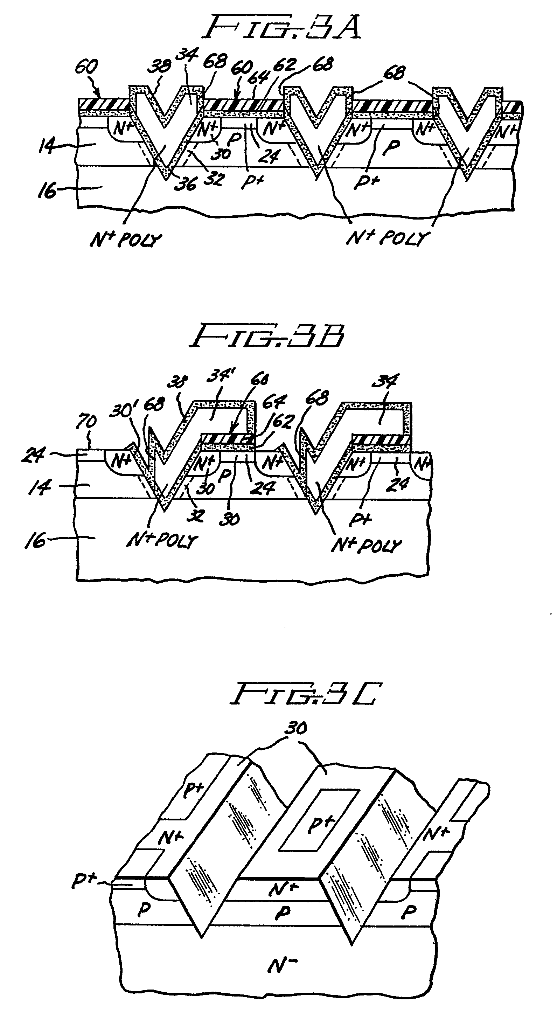

One exemplary process in accordance with the invention for fabricating the FIG. 1 device 10 will now be described with reference to FIGS. 2A-2E and FIG. 3A. For convenience, identical reference numerals are employed to designate similar or corresponding elements.

First, as generally depicted in FIG 2A, a semiconductor wafer is provided including the upper principal surface 20, and at least first, second and third successive contiguous layers corresponding to the layers 14, 16 and 18 (not shown) of FIG. 1. As is known in the art, such wafer is typically provided by starting with a $P^+$ silicon semiconductor substrate 18 (FIG. 1), then epitaxially growing the $N^-$ base layer 16 thereon. Then, the P base layer 14 is formed. For the shortest channel length, the P base layer 14 is preferably formed by diffusion, but the P base layer 14 can alternatively be epitaxially grown. The wafer preparation process may also include forming, as a portion of the P base layer 14, a relatively more heavily doped layer 24 of the same conductivity type as the P base layer 14 and immediately adjacent the first principal surface 20. Again, it may be noted that this particular layer 24 is beneficial (though optional) in the case of an IGT, but is necessary in the case of a MOSTOT where it forms the upper emitter region.

Next, a layer capable of serving as a first mask layer, generally designated 60, is formed on the principal surface 20, and suitably patterned. This is the particular step in the process depicted in FIG. 2A. The first mask layer 60, for example, comprises an oxide/nitride layer comprising a 500 Angstrom silicon dioxide layer 62 underlying a 1500 Angstrom silicon nitride layer 64. Openings 66 in the first mask 60 define the ultimate locations of the FIG. 1 V-grooves 28.

Next, as depicted in FIG. 2B, appropriate impurities are introduced through the openings 66 into the P base layer 14 to form at the upper principal surface 20 the $N^+$ cathode region 30. These impurities are at least laterally diffused part way under the mask layer 60 to define the $N^+$ cathode region 30, while leaving the portions 24 of the P base region 14 extending to the principal surface 20 to provide cathode-to-base shorts. These impurities may be introduced and diffused employing any one of a number of conventional techniques as are known in the art. It will be appreciated that the $N^+$ region 30 has a higher donor (N) dopant concentration than the acceptor (P) dopant concentration of $P^+$ layer 24.

In cases where the $P^+$ layer 24 is desired it may be preferable to form the $N^+$ region 30 prior to the $P^+$ layer 24. In particular, $N^+$ region 30 is partly diffused before the $P^+$ layer 24 dopant (e.g., boron) is implanted at sufficiently high energy to dope the silicon through the first mask layer 60. No additional mask is needed. This process order allows the use of $N^+$ region 30 dopants with lower diffusion coefficient than that of $P^+$ layer 24.

Next, as depicted in FIG. 2C, the first mask layer 60 is again employed, this time as an etch resist mask to form below the openings 66 "V-grooves" 28, which signifies herein any groove, regardless of precise configuration, extending entirely through the P base layer 14 and partly into the N base layer 16. As is known, such V-grooves may be formed employing a non-isotropic etch to form a notch sloping from the horizontal at 54.7° on a 100 -oriented silicon substrate. To achieve differing device breakdown characteristics as is known in the art, the V-grooves 28 may be of flat-bottomed V-shape which may be achieved by stopping an etching process that would otherwise form complete V-shape grooves. The V-grooves 28 may also be of flat-bottomed U-shape; which may be achieved through use of a non-isotropic etch on a 110 oriented silicon substrate, or by reactive ion etching on a silicon substrate oriented to either 111 or 100 . Alternatively, the V-grooves 28 may be of, generally, U-shape, which may be achieved through the use of an isotropic etchant provided the lateral extent of the etch does not eliminate all of $N^+$ region 30.

Again, it is significant to note that the same mask 60 is employed in both FIGS. 2B and 2C, and that the $P^+$ base extension regions 24, the $N^+$ cathode regions 30, and the V-grooves 28 are all precisely located with respect to each other by virtue of being defined by the same mask, thereby avoiding the need for repeated mask alignments, and attendant alignment tolerances. Thus, the lateral dimensions of each $N^+$ cathode region 30 may be held to an absolute minimum.

Next, as depicted in FIG. 2D, the gate insulating layer 36 is formed on the sides of the V-grooves 28 employing selective oxidation techniques. Significantly, the same mask 60 as before protects the tops of the $N^+$ source regions 30 and the $P^+$ base extension region 24 from oxidation during this step.

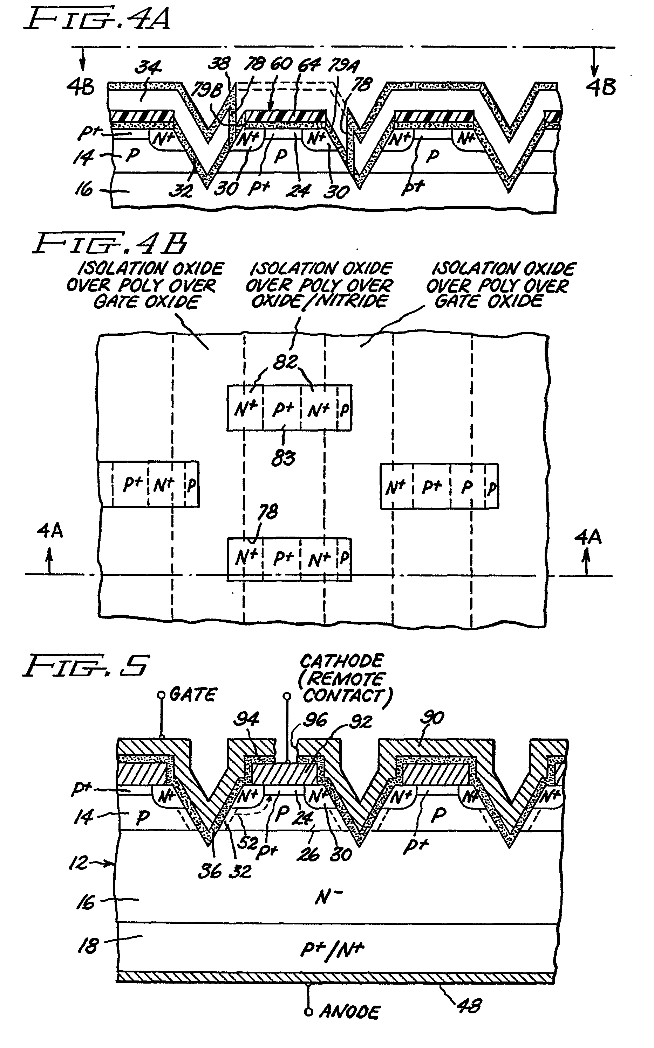

Next, a gate electrode is formed on the gate insulating layer 36. The process for forming the gate electrode structure of the FIG. 1 device is depicted in FIGS. 2E and 3, while an alternative process for forming an alternative structure is depicted in FIGS. 2E, 4A, and 4B. Thus, FIG. 2E is common to both alternatives.

Referring to FIG. 2E, a highly-doped (i.e. highly-conductive) polysilicon electrode layer 34 is formed over the entire wafer. Next, a second mask (not shown) is provided and is employed to etch through the polysilicon layer 34 to open upper main electrode contact windows 68, which may be seen in FIG. 3A. Then, as also depicted in FIG. 3A, all exposed surfaces of the polysilicon layer 34 are selectively oxidized in an oxidation step hereinafter termed the isolation oxidation, including the sidewalls of the upper main electrode contact windows 68 to form the gate electrode isolation insulation 38. During this particular selective oxidation step, it will again be appreciated that the first mask 60, in particular the nitride layer 64 thereof, protects the upper surfaces of the $P^+$ extension 24 and the $N^+$ cathode 30 from oxidation.

FIG. 3B is similar to FIG. 3A but illustrates a gross misalignment of the polysilicon gate regions 34', which a feature of the present invention, discussed below, can accommodate. In FIG. 3B, the gate regions 34' are shifted to the right, compared to the aligned gate regions 34 of FIG. 3A. This occurs when contact windows 68 are opened by a misaligned mask. In regard to the various oxide layers illustrated, such misalignment initially causes $N^+$ regions 30, at surface 30', to be uncovered. However, during the isolation oxidation the gate insulation layer 36 on the exposed surface 30' would be increased in thickness to be slightly thicker than the isolation oxide 38. Thus, when electrode contact windows 68 are thereafter opened down to the $N^+$ regions 30 and $P^+$ regions 24 at surface 70, the previously-uncovered silicon 30' and polysilicon 34 will be encased either by a thick oxide at least the thickness of oxide 38 or by the first mask layer be composed in the present, exemplary example by 500 of oxide overlain by 1500 of nitride.

21

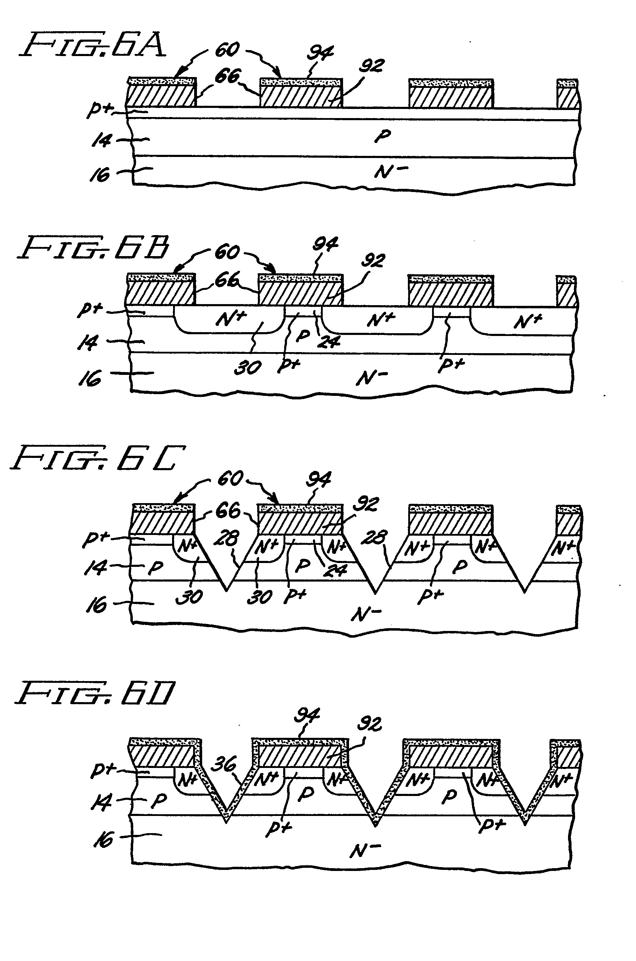

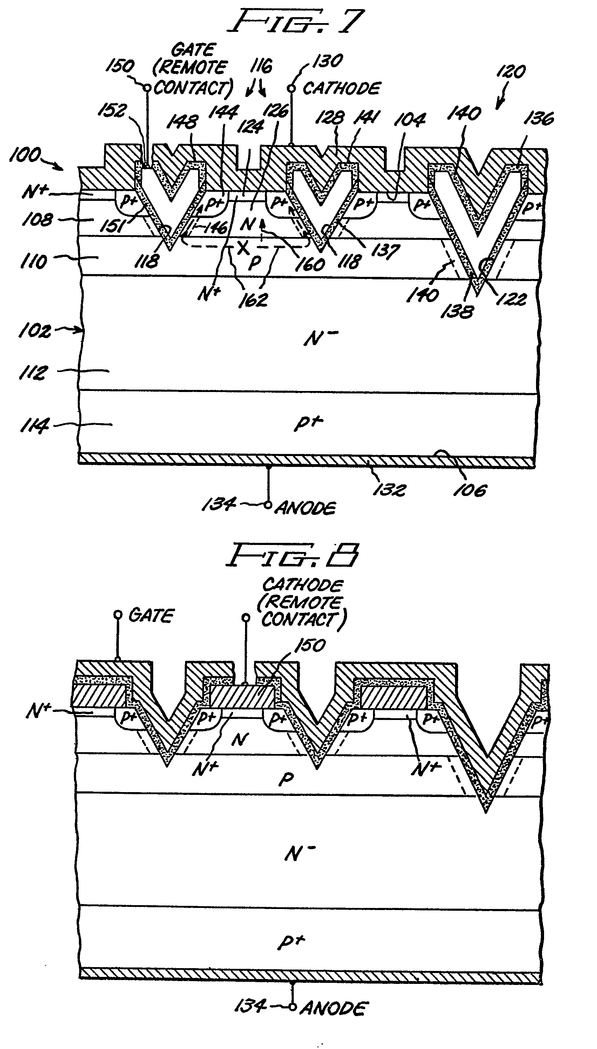

The misalignment in the FIG. 3B device, upon superficial consideration, would appear to render the device inoperative.  This is because, associated with each polysilicon gate region 34', the respective left-hand channel 32 cannot conduct current since the gate region 34' does not fully overlie the channel, and the respective, right-hand channel appears to be electrically isolated from surface 70 where main terminal metallization is to be applied.  However, by configuring the $N^+$ regions 30 as illustrated in FIG. 3C, the right-hand channel 32 is assured of electrical contact to the main terminal metallization which is to be applied to surface 70.  In particular, the $N^+$ regions 30 extend completely across each unetched finger at regular intervals along the fingers.  For clarity of illustration, the FIG. 3C device is shown without the silicon nitride mask layer, which would normally be present at that particular point in the process.  The FIG. 3C modification of $N^+$ regions 30, which requires the use of an additional mask, may be incorporated into the FIG. 1 and the below-discussed FIG. 7 device structures.  The additional mask requires no critical alignment since it is configured, for example, of stripes aligned approximately at 90° to the first mask layer 60.

As depicted in FIG. 3A, the openings 68 defined by the second mask and extending along the surface of the structure are parallel to the longitudinal axes of the V-grooves 28 and are substantially co-extensive with the V-grooves.

The process further includes the step of providing an upper main electrode, such as the FIG. 1 cathode electrode 44, in electrical contact with the channel-terminating upper electrode region, e.g. the $N^+$ cathode region 30, and with the extending portion of the first semiconductor layer 14, e.g. the $P^+$ extension 24, all with reference to FIG. 1. Continuing with the foregoing process description and with reference to FIG. 3A, the step of providing an upper main electrode more particularly comprises selectively removing the first mask 60 comprising silicon nitride 64 and the relatively thin silicon oxide layer 62 (by a light oxide etch) to expose the $N^+$ emitter 30 and the $P^+$ extending portion 24 both of which, up to this point, have been protected by the silicon nitride mask 64 during the various selective oxidation steps. A contact window mask (not shown) is used to remove the isolation oxide 38 over a remote portion of the $N^+$ polysilicon layer 34. Masking for this window is independent of the masking requirements for the illustrated portion of the device. Thereafter, suitable electrode metal, such as aluminum, is evaporated onto the wafer surface and patterned to form a contact pad (not shown) to the $N^+$ polysilicon gate 34 and the main terminal metallization (not shown) which contacts each of the illustrated $P^+$ regions 24 and $N^+$ regions 30.

An alternative process and the resultant device structure are depicted in FIGS. 4A and 4B which, in the processing, follow FIG. 2E in place in FIG. 3A. In overview, by sacrificing some gate width, all of the critical alignment steps for the IGT 10 (or an MCT) can be eliminated. In FIGS. 4A and 4B, the polysilicon gate electrode layer 34 is patterned by means of a second mask (not shown) by opening a plurality of upper main contact windows 78 which generally run longitudinally at right angles to the longitudinal axes of

RD-15.248

0159663

the V-grooves 28. These relatively short openings 78, accordingly, do not interrupt the overall continuity of the polysilicon gate electrode layer 34. This particular technique is not critical insofar as mask alignment is concerned, as is illustrated, for example, in the deliberate misalignment depicted in FIGS. 4A and 4B. Moreover, while each of the openings 78 in FIG. 4B spans essentially one unit cell, these openings 78, or selected ones of the openings 78, may span a plurality of unit cells.

Referring to simplified plan view of FIG. 4A, through a major immediate portion of window 78 there exists, as indicated, the silicon nitride layer 64 and underlying thin oxide layer 62 ready to be etched away for automatic contact to the intermediate $P^+$ extending region 24 and the $N^+$ contact regions 30. At the extreme ends of each of window 78 there exists, as indicated, isolation oxide 38 overlying the polysilicon gate electrode layer 34, this oxide 38 and layer 34 remaining in the final device structure. Accordingly, it will be appreciated that each of the openings 78 extends far enough to span a pair of the $N^+$ cathode regions 30 and the intermediate $P^+$ extending region 24.

In FIG. 4B the polysilicon region 34 is indicated as overlying gate oxide layer 36 where the V-etch was done and nitride mask layer 30 on the unetched surface. The sides and top of the polysilicon are protected by isolation oxide 38. In the polysilicon openings 78 oxide layers 79A and 79B are grown substantially during the isolation oxidation step and are each at least as thick as isolation oxide 38. Regions 82 and 83 contain the nitride mask layer 64 over the N$^+$ region 30 and P$^+$ layer 24 (or P base 14) respectively.

Final processing of the device of FIGS. 4A and 4B proceeds as described above with reference to FIG. 3A. In particular, the nitride mask layer 60 is removed where exposed through the windows 78. As before a contact window mask (not shown) is employed to remove isolation oxide 38 over some remote portion of the gate polysilicon 34. Then the entire upper surface of the device is metallized and patterned into a polysilicon contact bonding pad (not shown) and main terminal metallization (not shown).

With reference now to FIG. 5, depicted is an IGT device structure wherein the upper main electrode metallization comprises a refractory metal, such as molybdenum silicide, to which external electrical access is provided by a remote contact. In the FIG. 5 device, the uppermost metallization layer 90 is gate metallization, and the upper main electrode layer 92 comprising molybdenum silicide is encased in isolation oxide 94. Electrically, the FIG. 5 device functions in a manner comparable to the FIG. 1 device.

The process for manufacturing the FIG. 5 device initially proceeds as generally depicted in FIGS. 6A, 6B, and 6C. The process steps depicted in FIGS. 6A, 6B and 6C are generally comparable to those of FIGS. 2A, 2B and 2C, with the exception that the first mask 92 comprises refractory metal silicide, which remains in the final device structure. Thus, this first mask 92 positively locates the upper electrode metallization, since it constitutes the upper electrode metallization, as well as positively locating the N$^+$ cathode 30 formed by diffusion, and the V-groove 28. As may be seen in FIGS. 6A, 6B and 6C, the molybdenum silicide mask 92 preferably has an oxide layer 94 formed on the upper surface thereof.

This process continues as depicted in FIG. 6D, wherein the gate insulating layer 36 is formed on the groove sidewalls. At the same time, sides of the molybdenum silicide mask/electrode 92 are oxidized.

Next, at least one cathode electrode opening, represented in FIG. 5 as a remote opening 96, is formed through the molybdenum silicide oxide layer 94. The wafer is metallized, and the metal is then patterned to separate the gate electrode and the remote cathode electrode.

Referring now to FIG. 7, depicted is a V-groove MOSTOT 100 in accordance with the invention. The FIG. 7 MOSTOT 100 comprises a semiconductor body 102 having first and second opposed principal surfaces 104 and 106 and including first, second, third and fourth successive layers 108, 110, 112, and 114 of alternate conductivity type. The first and third layers 108 and 112 are of one conductivity type, in this example, of N conductivity type. The second and fourth layers 110 and 114 are of opposite conductivity type, in this example, of P conductivity type.

This illustrated portion of the FIG. 7 MOSTOT structure includes two types of MOSFETs, a pair of P-channel enhancement mode turn-off MOSFETs 116 corresponding to the two left-most V-grooves 118 in the FIG. 7 orientation, and a single N-channel enhancement mode turn-on MOSFET 120 corresponding to the relatively deeper V-groove 122 on the right side of FIG. 7. A completed MOSTOT typically includes several thousand turn-off MOSFETs such as MOSFETs 116, and a much lesser

RD-15,248

0159663

number of turn-on MOSFETs such as MOSFET 120. At this point, it may be noted that the present invention is concerned primarily with the structure of the turn-off MOSFETs 116 which give the overall MOSTOT device 100 its advantageous turn-off characteristic. The turn-on MOSFET 120 is merely representative of a variety of techniques which may be employed to initially gate the overall thyristor device 100 into conduction.

In this regard, in FIG. 7 it will be appreciated that the four layers 108, 110, 112, and 114 comprise a four-layer PNPN thyristor structure. However, for proper operation, the first layer 108 includes a portion 124 of relatively higher doping concentration, e.g. an $N^+$ emitter 124, immediately adjacent the first principal surface 104, and another portion 126 of relatively lower doping concentration separated from the first principal surface 104 by the $N^+$ portion 124.

Thus, the two intermediate layers 110 and 112 comprise the P base and $N^-$ base, respectively, of a four-layer thyristor. The portions 124 and 126 of the layer 108 comprise thyristor cathode regions, more particularly, an $N^+$ emitter region 124 and an N emitter region 126. Finally, the $P^+$ region 114 comprises a thyristor anode region, which may also be termed a $P^+$ emitter. Consistent with this structure, cathode metallization 128 is formed generally on the upper surface 104 of the device in contact with the $N^+$ emitter 124 and connected to a device cathode terminal 130, and anode metallization 132 is formed on the second principal surface 106 in contact with $P^+$ emitter region 114 and is connected to a device anode terminal 134.

As noted above, the turn-on transistor 120 is provided for gating the thyristor device, as thus far described, into conduction. More particularly, the turn-on transistor 120 comprises an insulated gate electrode 136, preferably of polysilicon, separated from the sidewalls of the V-groove 122 by gate oxide 138, and from the cathode metallization 128 by gate isolation oxide 140. The polysilicon gate 136 is configured and arranged such that when an appropriate bias voltage is applied thereto, in this example, a positive voltage, a conduction channel is induced in a channel region 142, which serves to gate the device into conduction. Thus, for turn-on, the device 100 is shown in representative form as a MOS-gated thyristor, although, again, this particular turn-on method is exemplary only.

The turn-off MOSFETs 116 include the above-mentioned V-grooves 118 which extend from the first principal surface 104 through the $N^-$ emitter layer 118 into the P base layer 120. Thus, the portion 126 of the N emitter 108 of relatively lower doping concentration intersects sides of the V-grooves 118 along lower portions thereof. Off-gate polysilicon regions 148 are separated from the respective V-surfaces 118 by gate oxide 137 normally grown with gate oxide 138 of turn-on transistor 120. Each off-gate polysilicon region 148 has an isolation oxide 141 on its top and sidewalls, preferably grown at the same time as isolation oxide region 140.

Channel-terminating upper electrode regions 144 of the opposite conductivity type, e.g. $P^+$ MOSFET terminal regions 144, are formed within the first layer 108 immediately adjacent upper portions of the

28

V-grooves 118 and intersect both the first principal surface 104 and the upper portions of the V-grooves 118. The $P^+$ drain regions 144 and the P base region 110 together define the length of channel regions 146 extending therebetween and existing within the N emitter region 108.

Finally, an insulated gate electrode 148, preferably of polysilicon, overlies the channel regions 146 and is configured such that an inversion channel electrically connecting the $P^+$ MOSFET terminal regions 144 and the P base layer 110 is induced in the channel regions 146 upon application to the gate electrode 148 of a bias voltage having predetermined polarity and magnitude. In this example, it is a negative gate voltage which biases the turn-off MOSFETs 116 into conduction, and thus turns off the overall MOSTOT device 100. The polysilicon gate electrode 148 is connected to a device gate terminal 150 by means of a remote gate contact represented at 152.

The operation of the FIG. 7 MOSTOT device 100 is generally as described in the above-referenced European application 82109164.2. However, in brief summary, a four-layer PNPN thyristor structure can, for many analysis purposes, be represented by a two-transistor analogue comprising an upper NPN bipolar transistor and a lower PNP bipolar transistor. The base of the upper NPN transistor is connected to (and comprises the same device region as) the collector of the lower PNP transistor, and the base of the lower PNP transistor corresponds to (and comprises the same device region as) the collector of the upper NPN transistor. The overall thyristor device is regenerative, i.e., it latches into a conducting state, when the device structure and current flow are such that the sum of the common-base current gains of the two bipolar transistors is in excess of unity. In the MOSTOT 100, the upper NPN bipolar transistor of the two-transistor analogue comprises layers 108, 110 and 112. The lower PNP bipolar transistor comprises layers 110, 112 and 114.

When the MOSTOT 100 is conducting, device current flows from the anode electrode 132 to the cathode electrode 128, and the bipolar transistors of the analogue representation operate in a regenerative mode; that is, the collector current for one transistor drives the base of the other transistor and vice versa.

Significantly, as a part of this regenerative operation, hole current, generally indicated by the arrow 160, flows from the P base region 100 to the N emitter region 108. In the two-transistor analogue, this hole current represented by the arrow 160 may be viewed as base current of the upper NPN bipolar transistor, forward-biasing the base/emitter PN junction.

For device turn-off, upon application of negative bias voltage to the polysilicon gate electrode 148, a bypass current path, represented by the arrows 162, is established, which draws away or "steals" hole current from the hole current path represented at 160. When the bias voltage on the gate electrode 148 reaches a sufficient magnitude, the resistance through the turn-off MOSFETs 116 is sufficiently lowered to a value which reduces the base-to-emitter voltage of the upper NPN bipolar transistor. Thus, the regenerative action of the thyristor structure is no longer sustained, and the device turns off.

From this description and from FIG. 7, it will be appreciated that the resistance of the current paths 162 is an important parameter in determining the turn-off characteristics of the device 100. The lower the resistance of the bypass current paths 162, the greater the device current which can be turned off. Also, from FIG. 7, it will be appreciated that a contributor to the resistance of the bypass current paths 162 is the lateral distance between the worst-case point, represented at "X", to the lower extremities of the channels 146. It will further be appreciated that the processes of the present invention, by reducing this lateral distance to a minimum, result in advantageous structures.

In one specific structural example, the dimensions of the FIG. 7 MOSTOT 100 are such that the depth of the $N^+$ emitter region 124 is about 1 micron below the surface 104; the depth of the $P^+$ MOSFET terminal region 144 is about 2 microns below the surface 104; the depth of the N base region 108 is about 3 microns below the surface 104; and the depth of the P base region 110 is about 8 microns below the surface. Typical impurity concentrations are as follows:

<u>Doping Table</u>

| | |
|---|---|
| $N^+$ emitter 124 | $5 \times 10^{18}/cm^3$ |
| $P^+$ MOSFET terminal 144 | $2 \times 10^{19}/cm^3$ |
| N Base portion 126 | $5 \times 10^{16}/cm^3$ |
| P Base 110 | $6 \times 10^{16}/cm^3$ |

These dimensions and impurity concentrations result in a P base 110 resistance of 300 ohms per square which, in a finger-type structure, results in a lateral P base resistance of less than 60 micro-ohms - cm². In other words, at a current density of 1000 Amps/cm², the maximum lateral voltage drop generated in the P base 110 is 60 millivolts. To this is added a MOSFET channel 146 (5000 ohms per square) voltage drop of somewhat less than 200 millivolts at 1000 Amps/cm². Based on one-dimensional turn-off calculations, a MOSTOT switching current can be predicted of (1000) x (1/0.4) x (0.8/0.260) = 7.7 kiloamps/cm², where 0.4 is the hole fraction of the P base 100 current, and 0.8 volts is the critical $N^+$ emitter 124 to P base 110 potential. In the FIG. 7 MOSTOT 100, both the P base 110 and N emitter 108 layers are preferably epitaxial layers, which permits a low turn-on MOSFET 120 gate threshold, a low turn-off MOSFET 116 gate threshold, and a relatively low sheet resistance for both layers 110 and 108.

Comparing the structures of the FIG. 7 MOSTOT 100 with the structure of the FIG. 1 IGT 10, it will be appreciated that the upper electrode regions (neglecting the turn-on MOSFET 120 of FIG. 7) are substantially identical, with the exception that the conductivity types are opposite in the two cases. Accordingly, it will be further appreciated that substantially identical fabrication techniques can be employed, except that the semiconductor wafer which is provided as the first step in the process has four rather than three layers. For fabricating the FIG. 7 MOSTOT 100, the first layer 108 is of N conductivity type. For fabricating the FIG. 1 IGT 10 as summarized above, the first layer 14 is of P conductivity type.

RD-15,248

0159663

FIG. 8 depicts an alternative MOSTOT structure differing from FIG. 7 in that molybdenum silicide cathode electrodes 150 are employed extending to remote cathode contacts. Thus, the FIG. 8 MOSTOT bears the same relationship to the FIG. 7 MOSTOT as the FIG. 5 IGT bears to the FIG. 1 IGT. Similarly, it will be appreciated that essentially identical method steps as described above for fabricating the FIG. 5 IGT may be employed to fabricate the FIG. 8 MOSTOT, however, again, starting with a four-layer wafer, rather than a three-layer wafer.

It will further be appreciated that the alternative method of FIGS. 4A and 4B may be employed to fabricate a MOSTOT device, generally comparable to the FIG. 7 MOSTOT, but having main electrode contact windows at generally right angles to the V-grooves 118.

The foregoing describes various forms of a semiconductor device having a low lateral voltage drop in the device base region. In an IGT, this results in a higher current-carrying capacity before latch-on occurs, while, in a MOSTOT, more device current can be carried and still turned off. Methods of fabrication of these devices have been described, such methods reducing or eliminating the number of required, critical alignment masking steps and also permitting a greater degree of tolerance in certain mask alignments so as to increase device yields and reduce device cost.

While specific embodiments of the invention has been illustrated and described herein, it is realized that numerous modifications and changes will occur to those skilled in the art. It is therefore to be understood that the appended claims are intended to

RD-15,248

cover all such modifications and changes that fall within the true spirit and scope of the invention.

CLAIMS

1.  A process for manufacturing an insulated-gate semiconductor device of V-groove configuration, said process comprising:

providing a semiconductor wafer having a principal surface and including at least first, second and third successive contiguous layers, the first layer being of one conductivity type and extending to the principal surface and the second layer being of opposite conductivity type;

forming on the principal surface a layer of a material constituting a first mask;

forming at least one elongated opening in the first mask layer to define the ultimate location of a V-groove;

introducing into the first semiconductor layer through each openings in the first mask dopant impurities appropriate to form at the principal surface a channel-terminating electrode region of the opposite conductivity type, and at least laterally diffusing the impurities part way under the mask to form the channel-terminating electrode region while leaving a portion of the first layer extending to the principal surface;

applying an etchant through each opening in the first mask so as to form below each opening a V-groove extending from the principal surface through the first semiconductor layer and part way into the second semiconductor layer;

forming a gate insulating layer on the sides of the V-groove;

forming a gate electrode on the gate insulating layer; and

providing an upper main electrode in electrical contact with the channel-terminating electrode region and with the extending portion of the first semiconductor layer.

2. A process in accordance with claim 1, wherein the step of providing a semiconductor wafer includes forming, as a portion of the first semiconductor layer, a relatively more heavily doped layer of the one conductivity type immediately adjacent the principal surface.

3. A process in accordance with claim 1, wherein the third layer of the semiconductor wafer is of one conductivity type and wherein the process further comprises providing a lower main electrode in electrical contact with the third layer.

4. A process in accordance with claim 2, wherein the third layer of the semiconductor wafer is of one conductivity type and wherein the process further comprises providing a lower main electrode in electrical contact with the third layer.

5. A process in accordance with claim 2, wherein the semiconductor wafer includes a fourth layer contiguous with the third layer, the third and fourth layers being of the one and opposite conductivity types, respectively, and wherein the process further comprises providing a lower main electrode in electrical contact with the fourth layer.

6. A process in accordance with claim 1, wherein the step of forming on the principal surface a first mask layer comprises forming a silicon nitride mask layer.

7. A process in accordance with claim 6, wherein the step of forming a gate electrode comprises:

forming a highly doped polysilicon layer over the entire wafer;

providing a second mask over the polysilicon layer;

etching through the polysilicon layer to open upper main electrode contact windows to form gate electrode isolation insulation; and

opening remote gate electrode contact windows through the gate electrode isolation insulation.

8.   A process in accordance with claim 7, wherein the step of providing an upper main electrode comprises, subsequent to oxidizing the exposed surfaces of the polysilicon layer, removing the silicon nitride mask to expose the channel-terminating electrode region and the extending portion of the first semiconductor layer, whereby the silicon nitride mask layer protects the channel-terminating electrode region and the extending portion of the first semiconductor layer from oxidation.

9.   A process in accordance with claim 7, wherein the upper main electrode contact windows defined by the second mask are parallel to and substantially co-extensive with the V-groove.

10.   A process in accordance with claim 8, wherein a plurality of parallel elongated openings are formed in the first mask and wherein said etchant is applied through each of said openings, such that a plurality of V-grooves are formed in the semiconductor wafer during the step of applying said etchant through each of said openings and such that between each adjacent pair of V-grooves a pair of channel-terminating electrode regions are formed during the step of introducing dopant impurities through each of said openings in the first mask, the pair of channel-terminating upper electrode regions being separated by an intermediate extending portion of the first semiconductor layer.

11. A process in accordance with claim 10 including the step of forming upper main electrode contact windows at generally right angles to the V-grooves and extending far enough to span a pair of channel-terminating upper electrode regions and the intermediate extending portion.

12. A process in accordance with claim 1, wherein the step of forming on the principal surface a first mask layer comprises forming a refractory metal silicide layer which remains in the completed device to form the upper main electrode.

13. A process in accordance with claim 12, wherein the step of providing an upper main electrode comprises oxidizing the exposed surfaces of the refractory metal silicide layer including sidewalls of the elongated opening in the first mask to form upper main electrode isolation insulation.

14. A metal-oxide-semiconductor turn-off thyristor of V-groove configuration comprising:

a semiconductor body having first and second opposed principal surfaces and including first, second, third and fourth successive layers of alternate conductivity type, said first and third layers being of one conductivity type and said second and fourth layers being of opposite conductivity type;

said first layer being adjacent said first principal surface and including two portions of differing doping concentration, one of said portions having a relatively higher doping concentration being immediately adjacent said first principal surface, and the other of said portions having a relatively lower doping concentration being separated from said first principal surface by said one portion;

a V-groove extending from said first principal surface through said first layer such that at least said other portion of said first layer abuts a side of said V-groove along a lower portion of said V-groove;

a channel-terminating electrode region of the opposite conductivity type formed within said first layer immediately adjacent an upper portion of said V-groove and extending to both said first principal surface and said V-groove upper portion, said channel-terminating electrode region and said second layer together defining the length of a channel region therebetween and within said other of said first layer portions;

a first main terminal electrode in electrical contact at said first principal surface with said one of said first layer portions and with said channel-terminating upper electrode region;

a second main terminal electrode in electrical contact at said second principal surface with said fourth layer; and

an insulated gate electrode overlying said channel region and configured such that an inversion channel electrically connecting said channel-terminating electrode region and said second layer is induced in said channel region upon application to said gate electrode of a bias voltage having predetermined polarity and magnitude.

15. The thyristor of claim 14 wherein said first main terminal electrode comprises metal silicide.

16. An insulated-gate transistor of V-groove configuration comprising:

a semiconductor body having first and second opposed principal surfaces and including first, second and third successive layers of alternate conductivity type, said first and third layers being of one conductivity type and said second layer being of opposite conductivity type;

said first layer being adjacent said first principal surface and including two portions of differing doping concentration, one of said portions having a relatively higher doping concentration and being immediately adjacent said first principal surface, and the other of said portions having a relatively lower doping concentration and being separated from said first principal surface by said one portion;

a V-groove extending from said first principal surface through said first layer such that at least said other portion of said first layer abuts a side of said V-groove along a lower portion of said V-groove;

a channel-terminating electrode region of the opposite conductivity type formed within said first layer immediately adjacent an upper portion of said V-groove and abutting both said first principal surface and said V-groove upper portion, said channel-terminating electrode region and said second layer together defining the length of a channel region therebetween and within said other of said first layer portions;

a first main terminal electrode in electrical contact at said first principal surface with said one of said first layer portions and with said channel-terminating electrode region;

a second main terminal electrode in electrical contact at said second principal surface with said third layer; and

an insulated gate electrode overlying said channel region and configured such that an inversion channel electrically connecting said channel-terminating electrode region and said second layer is induced in said channel region upon application to said gate electrode of a bias voltage having predetermined polarity and magnitude.

17. The transistor of claim 16 wherein said first main terminal electrode comprises metal silicide.

18. A MOS field-effect transistor of V-groove configuration comprising:

a semiconductor body having first and second opposed principal surfaces and including first, second and third successive layers, said first layer being of one conductivity type and said second and third layers being of opposite conductivity type;

said first layer being adjacent said first principal surface and including two portions of differing doping concentration, one of said portions having a relatively higher doping concentration and being immediately adjacent said first principal surface, and the other of said portions having a relatively lower doping concentration and being separated from said first principal surface by said one portion;

a V-groove extending from said first principal surface through said first layer such that at least said other portion of said first layer abuts a side of said V-groove along a lower portion of said V-groove;

a channel-terminating electrode region of the opposite conductivity type formed within said first layer immediately adjacent an upper portion of said V-groove and abutting both said first principal surface and said V-groove upper portion, said channel-terminating electrode region and said second layer together defining the length of a channel region therebetween and within said other of said first layer portions;

a first main terminal electrode in electrical contact at said first principal surface with said one of said first layer portions and with said channel-terminating electrode region;

a second main terminal electrode in electrical contact at said second principal surface with said third layer; and

an insulated gate electrode overlying said channel region and configured such that an inversion channel electrically connecting said channel-terminating electrode region and said second layer is induced in said channel region upon application to said gate electrode of a bias voltage having predetermined polarity and magnitude.

19.  The transistor of claim 18 wherein said first main terminal electrode comprises metal silicide.

FIG. 1

FIG. 2A

FIG. 2B

0159663

*FIG. 2C*

*FIG. 2D*

*FIG. 2E*

## FIG.3A

## FIG.3B

## FIG.3C

## FIG. 4A

34  38  78 60 64 79A
79B                    78
4B ←                              → 4B

P+        N+      N+      P      N+      N+
14 — P        P              P+
16 —      32  30 P+  24  30              P+

## FIG. 4B

ISOLATION OXIDE        ISOLATION OXIDE        ISOLATION OXIDE
OVER POLY OVER        OVER POLY OVER        OVER POLY OVER
GATE OXIDE           OXIDE/NITRIDE         GATE OXIDE

82

| N+ | P+ | N+ | P |
83

| P+ | N+ | P |                              | N+ | P+ | P | P |

4A ↑                                                    ↑ 4A

78
| N+ | P+ | N+ | P |

## FIG. 5

GATE          CATHODE
(REMOTE
CONTACT)

94    96  92        90

P+        N+      N+      N+      N+      N+
14 — P          P 24              P
52 P+   26 30              P+
12 →
36 32
16 —              N−

18 —              P+/N+

ANODE                              48

FIG.6A

FIG.6B

FIG.6C

FIG.6D

## FIG. 7

GATE
(REMOTE
CONTACT)

CATHODE

## FIG. 8

GATE

CATHODE
(REMOTE
CONTACT)